# EUROPÄISCHE PATENTSCHRIFT

(11) **EP 2 423 856 B1**
(45) Veröffentlichungstag und Bekanntmachung des Hinweises auf die Patenterteilung: **03.10.2012**
(21) Anmeldenummer: 10173837.5
(22) Anmeldetag: 24.08.2010
(51) Int. Cl.: G06K 19/077

(54) **Induktiv gekoppelter RFID-Transponder**
Inductive coupled RFID transponder
Transpondeur RFID couplé inductif

(43) Veröffentlichungstag der Anmeldung: 29.02.2012
(73) Patentinhaber: Siemens Aktiengesellschaft, 80333 München (DE)
(72) Erfinder: Kube, Roland, 90513, Zirndorf (DE); Stadelmann, Bernd, 91349, Egloffstein (DE)

(56) Entgegenhaltungen:
- WO-A2-03/030093
- US-A1- 2008 179 404

## Beschreibung

Die Erfindung betrifft einen RFID-Transponder gemäß dem Oberbegriff des Patentanspruchs 1, und ein Verfahren zur Herstellung eines RFID-Transponders gemäß dem Oberbegriff des Patentanspruchs 4.

Zur Kennzeichnung von Waren, Maschinen und anderen Gegenständen werden häufig mobile Datenspeicher eingesetzt, welche berührungslos ausgelesen werden können. Dabei werden die optisch lesbaren Barcode-Etiketten zunehmend durch elektromagnetische oder magnetisch schreib- und lesbare RFID-Etiketten (RFID = Radio-frequency Identification), auch RFID-Transponder genannt, ersetzt. Diese RFID-Transponder kommen in einer bevorzugten Ausführungsform ohne eigene Energieversorgung, beispielsweise Batterie, aus.

Bei RFID-Transpondern werden je nach Einsatzfall unterschiedliche Technologien eingesetzt. So werden beispielsweise zur Etikettierung von Kleidungsstücken und andere Fernfeld-Anwendungen die RFID-Transponder per Funk, also mittels elektromagnetischer Wellen, mit dem Lesegerät gekoppelt. Im Folgenden sollen jedoch induktiv gekoppelte RFID-Transponder betrachtet werden. Diese sind mittels eines magnetischen Wechselfeldes mit einem Schreib- und Lesegerät, kurz: Lesegerät, koppelbar und werden häufig bei industriellen Anwendungen eingesetzt, bei denen kurze Distanzen überbrückt werden müssen (sog. Nahfeld-Erfassung).

Die induktiv gekoppelten RFID-Transponder weisen regelmäßig eine oder mehrere Sende- und Empfangsspulen auf, mit denen der von einem Lesegerät erzeugte magnetische Fluss in eine Wechselspannung umgesetzt wird, wobei diese Wechselspannung zum einen die Betriebselektronik des RFID-Transponders mit Energie versorgt, und zum anderen Informationen enthält, die von dem Lesegerät zu dem RFID-Transponder übertragen werden, und umgekehrt. Zur Funktion des RFID-Transponder ist es unerlässlich, dass der vom Lesegerät erzeugte magnetische Fluss im Wesentlichen durch die Fläche der Spule geleitet wird, was jedoch in den Fällen problematisch ist, in denen der RFID-Transponder auf einer metallischen Oberfläche beziehungsweise in einer Mulde oder in einer Bohrung eines metallischen Werkstücks betrieben wird. In diesen Fällen wird oft ein großer Teil des magnetischen Flusses durch das metallische Werkstück und seitlich an der Sende- und Empfangsspule (kurz: Spule) vorbei geleitet, wobei die Energie des magnetischen Wechselfeldes zu einem großen Teil durch Wirbelstromverluste in Wärme umgesetzt wird und somit nicht mehr zur Versorgung des RFID-Transponders zur Verfügung steht. Umgekehrt werden auch die Aussendungen des RFID-Transponders bei einer Anordnung auf einem metallischen Werkstück zu einem großen Teil direkt in das metallische Werkstück geleitet, so dass ebenfalls eine unerwünschte Dämpfung zu beobachten ist.

Zur Lösung des Problems ist es bekannt, zwischen der Sende-und Empfangsspule des RFID-Transponders und einer metallischen Oberfläche beziehungsweise einem metallischen Werkstück einen Ferritkern (dazu gehören auch plattenförmige und topfförmige Bauteile aus Ferrit-material) vorzusehen, wodurch der magnetische Fluss, also die magnetischen Feldlinien, im Wesentlichen von einer dem metallischen Werkstück entgegensetzten Empfangsseite kommend durch die Fläche der Sende- und Empfangsspule geleitet und danach von dem metallischen Werkstück weg wieder zur Empfangsseite geleitet werden.

Bei den hier beschriebenen RFID-Transpondern handelt es sich also um eine Konstruktion, die zumindest aus drei Bauteilen besteht, nämlich der Betriebselektronik, der Sende- und Empfangsspule, Und dem Ferritkern. Hinzukommt in der Regel ein zweiteiliges Gehäuse, so dass regelmäßig fünf Bauteile miteinander verarbeitet werden müssen. Neben den dadurch gegebenen Aufwänden bei der Montage ist von Nachteil, dass die gebräuchlichen Ferritkerne aus sprödem Material bestehen und daher von einem Verwender, also einem Hersteller von RFID-Transpondern, der die Ferritkerne in aller Regel nicht selbst fertigt, nicht nachträglich verändert werden können, beispielsweise durch spanende Bearbeitung etc.. Daher sind mechanische Änderungen am Layout des RFID-Transponders nicht ohne weiteres möglich.

Es ist also eine Aufgabe der vorliegenden Erfindung, den mechanischen Aufbau gebräuchlicher RFID-Transponder zu vereinfachen.

Es ist ein Kerngedanke der vorliegenden Erfindung, für die induktiv gekoppelten RFID-Transponder anstelle der gebräuchlichen Ferritkerne ein Ferrit-Bauteil aus einem Verbundwerkstoff zu verwenden, welcher aus einem Kunststoff mit eingebetteten Ferritpartikeln (Ferritpulver) besteht und daher zur Führung des magnetischen Flusses im Bereich der Spule eingesetzt werden kann. Ein derartiger RFID-Transponder ist aus WO 03/030093 bekannt. Der Kunststoff, auf dem das Ferrit-Bauteil basiert, ist gemäß der Erfindung dazu laseraktivierbar ausgerüstet, wobei in den Bereichen, in denen die Oberfläche des Ferrit-Bauteils mit einem Laserstrahl bearbeitet wird, anschließend eine leitende metallische Schicht aufgebracht werden kann. Erfindungsgemäß wird durch dieses Verfahren eine flächige Spule als Sende-und Empfangsspule auf die Oberfläche des Ferrit-Bauteils aufgebracht, wobei in einer vorteilhaften Ausgestaltung der Erfindung durch dasselbe Verfahren Leiterbahnen und Löt-Pads für die Betriebselektronik auf das Ferrit-Bauteil aufgebracht werden können.

Die Lösung der Aufgabe sieht insbesondere einen RFID-Transponder für den Einsatz in einer RFID-Anordnung mit induktiver Kopplung gemäß dem Patentanspruch 1 vor, wobei zur Führung des magnetischen Flusses das Zusammenwirken einer Sende- und Empfangsspule mit einem Ferrit-Bauteil vorgesehen ist, wobei das Ferrit-Bauteil zur Führung des magnetischen Flusses aus einem Verbundwerkstoff aus einem Kunststoff und Ferritpulver besteht. Der Kunststoff ist dabei laserstrukturierbar ausgerüstet, so dass die Sende- und Empfangsspule durch zumindest eine mittels einer Laserbearbeitung vorkonturierte und metallisierte Leiterbahn in oder auf der Oberfläche des Bauteils gebildet werden kann. Bei einem solchen RFID-Transponder bildet das Ferrit-Bauteil und die Sende- und Empfangsspule ein integriertes Bauteil, so dass sich eine einfache Montage ergibt, die Anzahl der montierenden Bauteile verringert wird und sich eine kleinere Bauform des RFID-Transponders erreichen lässt.

Die Lösung der Aufgabe sieht weiter ein Verfahren zur Herstellung eines induktiv koppelbaren RFID-Transponders gemäß dem Patentanspruch 4 vor, wobei eine Betriebselektronik mit einer Sende- und Empfangsspule verbunden wird, und wobei ein Ferrit-aufweisendes Bauteil zur Führung des magnetischen Flusses durch die Sende- und Empfangsspule vorgesehen wird. Dabei wird das Bauteil aus einem Verbundwerkstoff aus einem Kunststoff und Ferrit-Pulver geformt, wobei der Kunststoff laseraktivierbar ausgerüstet ist, so dass mittels eines Laserstrahls die Kontur einer Leiterbahn zur Ausgestaltung der Sende- und Empfangsspule in oder auf einer Oberfläche des Bauteils aufgebracht bzw. eingebracht wird, wonach die Kontur metallisiert und mit der Betriebselektronik kontaktiert wird. Durch dieses Verfahren kann auf einfache und kostengünstige Weise ein RFID-Transponder kleiner Baugröße hergestellt werden, wobei Fehlfunktionen aufgrund von Rissen oder Brüchen in den gebräuchlichen spröden Ferrit-Bauteilen vermieden werden.

Vorteilhafte Ausgestaltungen des erfindungsgemäßen RFID-Transponders sind in den abhängigen Patentansprüchen 2 und 3 angegeben; vorteilhafte Ausgestaltungen des erfindungsgemäßen Verfahrens sind in den abhängigen Patentansprüchen 5 und 6 angegeben.

Vorzugsweise wird als der Kunststoff ein Flüssigkristallpolymer (LCP = Liquid Crystal Polymer) verwendet, welches robuste mechanische Eigenschaften und eine gute Beständigkeit gegen chemische Umwelteinflüsse aufweist. Dadurch ist es möglich, dass das Ferrit-Bauteil gleichzeitig auch einen Teil des Gehäuses des RFID-Transponders bildet. Überdies lässt sich Flüssigkristallpolymer leicht verarbeiten, insbesondere durch Gieß- oder Spritzgießverfahren, so dass bei einer ggf. notwendigen Formänderung des Ferrit-Bauteils nur eine Spritzgießform angepasst werden muss und sich die Beauftragung der Herstellung neuer harter Ferritkerne erübrigt.

Auf eine separate Leiterplatte für die Betriebselektronik kann verzichtet werden, wenn das Ferrit-Bauteil mittels der Laserbearbeitung auch vorkonturierte und metallisierte Leiterbahnen für die Bauteile der Betriebselektronik umfasst, wonach die elektronischen Bauelemente der Betriebselektronik direkt auf dem Ferrit-Bauteil angebracht werden können, beispielsweise durch Löten, Bonding, Kleben oder andere Kontaktierungsarten.

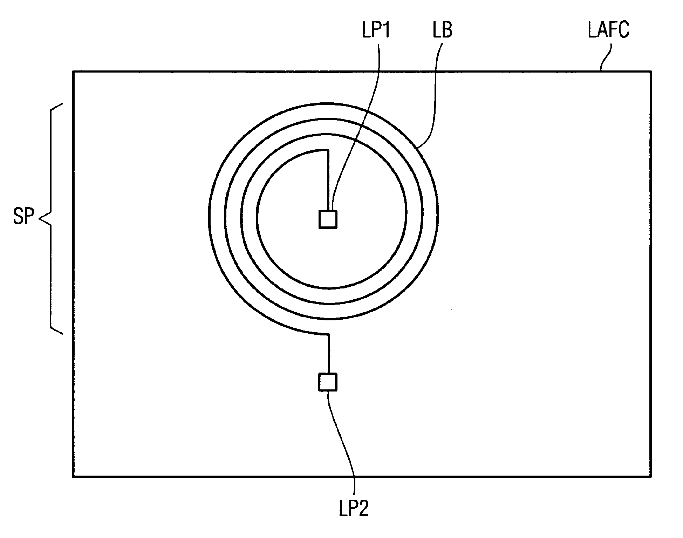

Ein Ausführungsbeispiel des erfindungsgemäßen RFID-Transponders und des Verfahrens zur Herstellung des RFID-Transponders wird nachfolgend anhand der Zeichnung erläutert.

Dabei zeigt die einzige Figur in schematischer Darstellung ein Ferrit-Bauteil mit einer Sende- und Empfangsspule, welche mittels eines Laserstrukturierungs- und Metallisierungsverfahrens aufgebracht ist.

In der Figur ist schematisch ein Ferrit-Bauteil LAFC ("Laser-Activated Ferrit-Compound") dargestellt, welches in seiner Basis aus einem Flüssigkristallpolymer ("LCP" = Liquid Crystal Polymer) besteht und laser-aktivierbar ausgerüstet ist. Dies bedeutet, dass mittels eines Laserstrahls Linien und Flächen auf der Oberfläche des Ferrit-Bauteils LAFC vorgezeichnet werden können, wodurch sich in den mit dem Laserlicht bearbeiteten Bereichen eine Veränderung der Oberflächen-Beschaffenheit ergibt; man spricht auch davon, dass in diesen bearbeiteten Bereichen ein sogenanntes modifiziertes Polymer vorliegt. Dieses Verfahren ist als LDS (Laser-Direkt-Strukturieren) bekannt. Es hat sich herausgestellt, dass das modifizierte Flüssigkristallpolymer, welches also mit einem Additiv für die Laser-Aktivierbarkeit ausgerüstet ist, mit Ferrit-Partikeln angereichert werden kann, ohne dass die isolierenden Eigenschaften (elektrische Isolation) und die Laser-Aktivierbarkeit beeinträchtigt werden. Das hier gezeigte Ferrit-Bauteil LAFC besteht aus einem solchermaßen mit Ferrit-Partikeln angereicherten und Laser-aktivierbaren Kunststoff, wobei mittels eines Laserstrahls zumindest eine Spule SP für einen induktiv koppelbaren RFID-Transponder durch Laserlicht vorgezeichnet und durch ein anschließendes Metallisierungsverfahren als elektrisch leitende Spule SP ausgebildet worden ist, die aus der Leiterbahn LB besteht. Im Gegensatz zu der hier schematisch gezeigten Spule SP ist die Spule SP einer realen Anordnung mit einem möglichst großflächigen Kernbereich, der frei von Leiterbahnen ist, ausgestaltet, wobei die Windungen der Spule im Randbereich konzentriert sind.

Je nach Intensität der Laser-Bearbeitung kann die Leiterbahn LB entweder auf der Oberfläche oder eingebettet in der Oberfläche des Ferrit-Bauteils LAFC angeordnet sein. In einer vorteilhaften, hier nicht dargestellten Ausführungsform sind auch sog. "Multilayer"-Anordnungen mit mehreren Schichten mit leitfähigen Strukturen herstellbar; insbesondere ist es möglich, die Rückseite des Ferrit-Bauteils mit Leiterbahnen zu versehen und diese mittels Durchkontaktierungen mit der Vorderseite zu verbinden.

Während in der Figur aus Gründen der Übersichtlichkeit nur eine Spule SP dargestellt ist, können bei einem realen Bauteil auch mehrere Spulen auf einem Ferrit-Bauteil realisiert werden, wobei diese Spulen beispielsweise parallel geschaltet oder mittels einer Schaltmatrix, insbesondere mittels einer Butler-Matrix, derart miteinander verknüpft werden, dass sich gegenüber einer einzelnen Spule SP verbesserte Sende- und Empfangseigenschaften ergeben.

Die Spule SP ist mit Kontaktierungsfedern LP1, LP2 ("Löt-Pad") versehen, wodurch eine (nicht dargestellte) Betriebselektronik des RFID-Transponders an die Spule SP angeschlossen werden kann. Dieses Kontaktieren kann beispielsweise durch Löten, durch Bonding, durch Federkontakte, durch Crimpen o.ä. erfolgen.

Obwohl in der Figur das Ferrit-Bauteil LAFC als rechtwinklige Platte dargestellt ist, sind abhängig von den Abmessungen des zu erstellenden RFID-Transponders und die spezifische Einbausituation auch andere Geometrien herstellbar, wobei infolge des vorzugsweise anzuwendenden Spritzgießverfahrens für eine geänderte Geometrie lediglich die verwendete Spritzgießform geändert werden muss. Außerdem kann ein gegossenes Werkstück aus dem hier vorgeschlagenen Material nachträglich bearbeitet werden, beispielsweise durch spanende Bearbeitung. Dies ist bei den herkömmlichen Ferritkernen im Allgemeinen nicht möglich, da dieses spröde Material bei mechanischer Bearbeitung häufig Risse oder Brüche davon trägt. An der (nicht dargestellten) Rückseite des Ferrit-Bauteils LAFC können Abstandshalter und Befestigungsmittel, sogenannte "Rastnasen" oder Eingriffe für Kunststoffschnappverbindungen, ein- oder angeformt sein.

In einer besonders vorteilhaften Ausgestaltung können neben der Leiterbahn LB und den Kontaktierungsflächen LP1, LP2 auch alle anderen Leiterbahnen und Kontaktflächen für die (nicht dargestellte) Betriebselektronik des RFID-Transponders auf dem Ferrit-Bauteil LAFC aufgebracht werden, so dass nach einer Bestückung mit den elektronischen Bauteilen keine weitere Leiterplatte oder Leiterfolie vorgesehen werden muss und eine Kontaktierung mit externen Bauelementen entfallen kann. Es entsteht ein sog. "MID" (moulded interconnected device), bei dem zusätzlich eine Führung des magnetischen Flusses in dieses Bauteil integriert ist.

Zusammengefasst handelt es sich bei dem Material, welches für den erfindungsgemäßen RFID-Transponder verwendet wird, um ein formgebendes Trägermaterial, welches als Bauteilträger eingesetzt werden kann und welches Leiterbahnstrukturen aufweist, mit denen Induktivitäten (Antennenstruktur) nachgebildet werden können. Dazu können durch die magnetischen Eigenschaften des eingesetzten Compound-Materials komplexe Ferritstrukturen gebildet werden, wodurch eine definierte Führung des magnetischen Flusses durch die Antennenstruktur (Spule SP) erreicht werden kann.

## Patentansprüche

1. RFID-Transponder für den Einsatz in einer RFID-Anordnung mit induktiver Kopplung,
wobei zur Führung des magnetischen Flusses das Zusammenwirken einer Sende- und Empfangsspule (SP) mit einem Ferrit-Bauteil (LAFC) vorgesehen ist,
wobei das Ferrit-Bauteil (LAFC) zur Führung des magnetischen Flusses aus einem Verbundwerkstoff aus einem Kunststoff und Ferritpulver besteht, **dadurch gekennzeichnet,**
**dass** der Kunststoff laserstrukturierbar ausgerüstet ist, und
**dass** die Sende- und Empfangsspule (SP) durch zumindest eine mittels einer Laserbearbeitung vorkonturierten und metallisierten Leiterbahn (LB) in oder auf der Oberfläche des Ferrit-Bauteils gebildet ist.

2. RFID-Transponder nach Patentanspruch 1,
**dadurch gekennzeichnet,**
**dass** der Kunststoff ein Flüssigkristallpolymer ist.

3. RFID-Transponder nach Patentanspruch 1 oder 2,
**dadurch gekennzeichnet,**
**dass** das Ferrit-Bauteil (LAFC) mittels einer Laserbearbeitung vorkonturierte und metallisierte Leiterbahnen (LB) der Betriebselektronik umfasst, wobei elektronische Bauelemente der Betriebselektronik auf dem Ferrit-Bauteil (LAFC) angebracht sind.

4. Verfahren zur Herstellung eines induktiv koppelbaren RFID-Transponders,
wobei eine Betriebselektronik mit einer Sende- und Empfangsspule (SP) verbunden wird, und wobei ein Ferrit-Bauteil (LAFC) zur Führung des magnetischen Flusses durch die Sende- und Empfangsspule (SP) vorgesehen wird, wobei
das Ferrit-Bauteil (LAFC) aus einem Verbundwerkstoff aus einem Kunststoff und Ferrit-Pulver geformt wird, **dadurch gekennzeichnet**, **dadurch gekennzeichnet, dass** der kunststoff laseraktivierbar ausgerüstet ist,
dass mittels eines Laserstrahls die Kontur einer Leiterbahn (LB) zur Ausgestaltung der Sende- und Empfangsspule (SP) in oder auf einer Oberfläche des Ferrit-Bauteils aufgebracht bzw. eingebracht wird, und
dass die Kontur metallisiert und mit der Betriebselektronik kontaktiert wird.

5. Verfahren nach Patentanspruch 4,
**dadurch gekennzeichnet,**
**dass** als der Kunststoff ein Flüssigkristallpolymer verwendet wird.

6. Verfahren nach Patentanspruch 4 oder 5,
**dadurch gekennzeichnet,**
**dass** das Ferrit-Bauteil (LAFC) mittels einer Laserbearbeitung mit vorkonturierten und metallisierten Leiterbahnen (LB) der Betriebselektronik versehen wird, wonach elektronische Bauelemente der Betriebselektronik auf dem Ferrit-Bauteil (LAFC) angebracht werden.

## Claims

1. RFID transponder for use in an RFID arrangement with inductive coupling,
wherein the interaction of a transmitting and receiving coil (SP) with a ferrite component (LAFC) is provided for guiding the magnetic flux,
wherein the ferrite component (LAFC) for guiding the magnetic flux consists of a composite material composed of a plastic and ferrite powder, **characterized**
**in that** the plastic is furnished in a laser-patternable manner, and
**in that** the transmitting and receiving coil (SP) is formed by at least one conductor track (LB) metalized and precontoured by means of laser processing in or on the surface of the ferrite component.

2. RFID transponder according to Patent Claim 1,
**characterized**
**in that** the plastic is a liquid crystal polymer.

3. RFID transponder according to Patent Claim 1 or 2,
**characterized**
**in that** the ferrite component (LAFC) comprises conductor tracks (LB) of the operating electronics that have been metalized and precontoured by means of laser processing, wherein electronic components of the operating electronics are fitted on the ferrite component (LAFC).

4. Method for producing an inductively coupleable RFID transponder,
wherein operating electronics are connected to a transmitting and receiving coil (SP), and wherein a ferrite component (LAFC) for guiding the magnetic flux through the transmitting and receiving coil (SP) is provided,
wherein the ferrite component (LAFC) is shaped from a composite material composed from a plastic and ferrite powder, **characterized in that** the plastic is furnished in a laser-activateable manner,
**in that** a laser beam is used to apply or introduce the contour of a conductor track (LB) for the configuration of the transmitting and receiving coil (SP) in or on a surface of the ferrite component, and
**in that** the contour is metalized and contact-connected to the operating electronics.

5. Method according to Patent Claim 4,
**characterized**
**in that** a liquid crystal polymer is used as the plastic.

6. Method according to Patent Claim 4 or 5,
**characterized**
**in that** the ferrite component (LAFC) is provided by means of laser processing with precontoured and metalized conductor tracks (LB) of the operating electronics, after which electronic components of the operating electronics are fitted on the ferrite component (LAFC).

## Revendications

1. Transpondeur RFID à utiliser dans un agencement RFID à couplage inductif
dans lequel pour le guidage du flux magnétique il est prévu la coopération d'une bobine (SP) d'émission et de réception et d'un module (LAFC) de ferrite,
dans lequel le module (LAFC) de ferrite est pour le guidage du flux magnétique en un matériau composite composé d'une matière plastique et d'une poudre de ferrite, **caractérisé**
**en ce que** la matière plastique est structurable par laser, et en ce que la bobine (SP) d'émission et de réception est formée dans ou sur la surface du module de ferrite par au moins une piste (LD) conductrice métallisée et précontourée au moyen d'un usinage laser.

2. Transpondeur RFID suivant la revendication 1,
**caractérisé**
**en ce que** la matière plastique est un polymère de cristal liquide.

3. Transpondeur RFID suivant la revendication 1 ou 2,
**caractérisé**
**en ce que** le module (LAFC) de ferrite comprend des pistes (LB) conductrices de l'électronique d'usine, métallisées et précontourées au moyen d'un usinage laser, des composants électroniques de l'électronique d'usine étant mis sur le module (LAFC) de ferrite.

4. Procédé de fabrication d'un transpondeur RFID pouvant être couplé inductivement,
dans lequel on relie une électronique d'usine à une bobine (SP) d'émission et de réception et dans lequel on prévoit un module (LACF) de ferrite pour guider le flux magnétique dans la bobine (SP) d'émission et de réception,
le module (LAFC) de ferrite étant formé d'un matériau composite composé d'une matière plastique et d'une poudre de ferrite,
**caractérisé en ce que** la matière plastique peut être activée par laser,
**en ce qu'**au moyen d'un faisceau laser on applique ou on introduit le contour d'une piste (LB) conductrice pour la formation de la bobine (SP) d'émission et de réception sur ou dans une surface du module de ferrite, et
**en ce que** l'on métallise le contour et on le met en contact avec l'électronique d'usine.

5. Procédé suivant la revendication 4,
**caractérisé**
**en ce que** l'on utilise comme matière plastique un polymère de cristal liquide.

6. Procédé suivant la revendication 4 ou 5,
**caractérisé**
**en ce que** l'on munit le composant (LAFC) de ferrite au moyen d'un usinage laser de pistes (LB) conductrices métallisées et précontourées de l'électronique d'usine, des composants électroniques de l'électronique d'usine, étant mis ensuite sur le module (LAFC) de ferrite.
